Europäisches Patentamt

European Patent Office

Office européen des brevets

(11) Publication number: 0 450 632 A2

# EUROPEAN PATENT APPLICATION

(21) Application number: 91105371.8

(22) Date of filing: 05.04.91

(51) Int. Cl.5: G11C 16/06

(30) Priority: 06.04.90 JP 90290/90

(43) Date of publication of application:
09.10.91 Bulletin 91/41

(84) Designated Contracting States:
DE FR GB

(71) Applicant: Kabushiki Kaisha Toshiba
72, Horikawa-cho Saiwai-ku
Kawasaki-shi(JP)

(72) Inventor: Kondo, Hitoshi, Intellectual Property
Division
KABUSHIKI KAISHA TOSHIBA, 1-1 Shibaura
1-chome
Minato-ku, Tokyo 105(JP)

Inventor: Sasaki, Satoshi, Intellectual
Property Division
KABUSHIKI KAISHA TOSHIBA, 1-1 Shibaura
1-chome
Minato-ku, Tokyo 105(JP)
Inventor: Maruyama, Tadashi, Intellectual
Property Division
KABUSHIKI KAISHA TOSHIBA, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) Nonvolatile semiconductor memory device.

(57) A decoder (32) contains AND gates ($42_0$, $42_1$, ...), which each receive a unique combination of internal address signals (a0 through a12, $\overline{a0}$ through $\overline{a12}$) consisting of a plurality of bits, and OR gates ($41_0$, $41_1$, ...), which each receive the output of the AND gates ($42_0$, $42_1$, ...) respectively and each also receive two types of control signals (CH0, CH1) alternately. During test, one of the two types of control signals (CH0, CH1) is activated depending on the logic level of the odd/even signal (ODD/$\overline{EVEN}$) supplied to the control circuit (36) which enables simultaneous selection of the word lines previously given the either even or odd addresses from the word lines (WL0, WL1, ...) connected to the memory cell array (33), on the basis of the output of the decoder (32).

FIG. 4

This invention relates to a nonvolatile semiconductor memory device that allows the erasing/rewriting of data and retains it even when power is turned off, such as EPROMs or EEPROMs.

Major semiconductor memory devices include DRAMs (Dynamic RAMs) and SRAMs (Static RAMS), which are called volatile memories and will lose the data in their memory cells when the power is off. Contrarily, memory devices that retain the data even when the power goes off are called nonvolatile memories, which are represented by ROMs (Read Only Memories). There are two types of ROMs: mask ROMs, into which data is written during the wafer process, and PROMs (Programmable ROMs), into which data can be written by suitable means after the memory IC chips are complete.

Such PROMs include several types: ones that allow data to be electrically written into only once by fusing the fuse elements built in the memory cells; EPROMs (Electrically Programmable ROMs) that enable the writing of data by electrical means and that permit erasure of the previously written data by radiation of ultraviolet rays to make it possible to rewrite data by electrical means; EEPROMs (Electrically Erasable and Programmable ROMs) that allow the erasing/rewriting of data by electrical means only; and others.

Erasable/rewritable memory devices other than the EEPROMs, including DRAMs, SRAMs, and EPROMs, have basically the same structure as that of EEPROMs. Electrically erasable/rewritable EEPROMs are the same as DRAMs and SRAMs in their basic functions. In general, DRAMs and SRAMs take only several hundred nanoseconds to write data, while EEPROMs take several milliseconds to do the same thing.

For erasable/rewritable semiconductor memory devices, the following tests are generally performed on their memory cell arrays before shipment:

(1) Repetition of test (nearly $10^2$ times) for erasing (all bits to the 1 state) and writing (0s to all bits)

(2) Write/read test of checker pattern (data of an alternate 1 and 0 string)

(3) Shelf test for a long time at a high temperature (under accelerated test conditions)

(4) Read test of the checker pattern (written in test (2))

Test (1), called the endurance test, is to check for the reliability of the memory cell array in repeating erase/write operation. The relationship between the number of erase/write operations and the occurrence of defective bits is known as the endurance characteristics. The commercial standard of the endurance characteristic is nearly 1% bit defective rate for nearly $10^4$ times of repetitious erase/write operations.

Tests (2) through (4), called the retention tests, are to check for the reliability with time after data write is complete. The relationship between the self test time and the occurrence of defective bits is known as the retention characteristics, whose commercial standard is nearly 1% bit defective rate after about 10 years of shelf test.

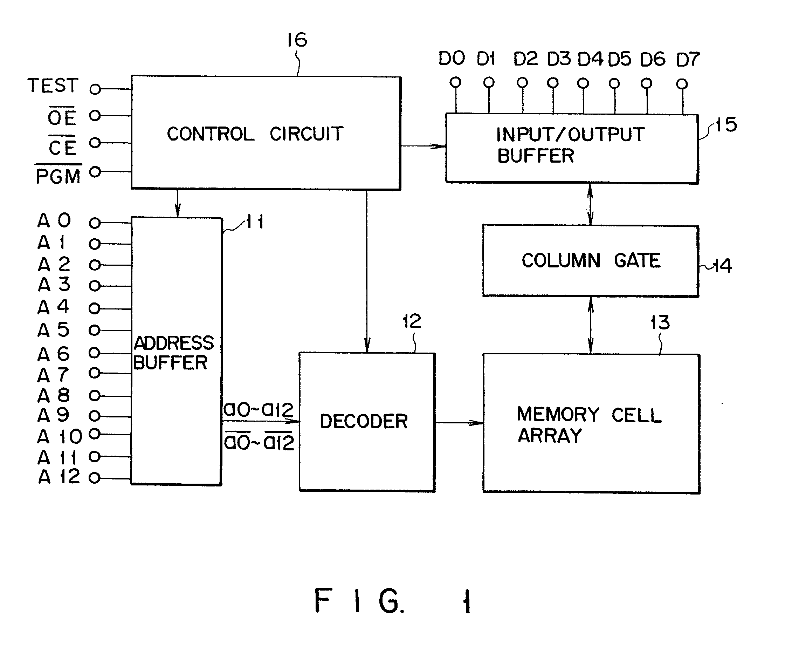

Fig. 1 is a block diagram for a conventional structure of the EEPROM mentioned above. Here, numeral 11 indicates an address buffer; 12 a decoder, 13 a memory cell array containing a plurality of nonvolatile memory cells; 14 a column gate; 15 an input/output buffer; and 16 a control circuit controlling the entire memory circuit.

In this circuit, it is assumed that an address signal supplied to the address buffer 11 is made up of 13 bits, A0 through A12, and that the data read from or written into via the input/output buffer 15 consists of 8 bits, D0 through D7. It is also assumed that the memory cell array 13 has the memory capacity to store 8192 (8K) words of data, each word being 8 bits long, or has 65536 (64K) memory cells.

With this EEPROM, to perform the above-mentioned endurance and retention tests, the control circuit 16 is supplied with an enable signal $\overline{OE}$, a chip enable signal $\overline{CE}$, a program signal $\overline{PGM}$, and a test signal TEST. Based on these input control signals, the circuit 16 produces various internal control signals to supply them to corresponding circuits in the memory device.

Normal data read/write operation in the EEPROM will be explained hereinafter. To read or write in the normal mode, the test signal TEST is set to the L (low) state. In read operation, $\overline{CE}$ and $\overline{PGM}$ are set so as to meet the conditions of $\overline{CE}$ = L and $\overline{PGM}$ = H (high), respectively. In this state, after the read address has been determined by the address signals A0 through A12, $\overline{OE}$ changes from the H (high) to the L (low) state. This causes an 8-bit word of data to be read from the memory cell array 13. The data passes through the column gate 14 and input/output buffer 15 and appears as data D0 through D7.

During write operation, with $\overline{CE}$ = L (low) and $\overline{OE}$ = H (high), after the write address has been determined by the address signal A0 through A12, and the write data level of each of D0 through D7 has been determined, the $\overline{PGM}$ changes from the H (high) to the L (low) state, causing every bit in a single word of data at the specified address to be set to the 1 state (or the erased state). After this, 0s are written into the specified bit positions of the 8 memory cells according to the write data D0 through D7.

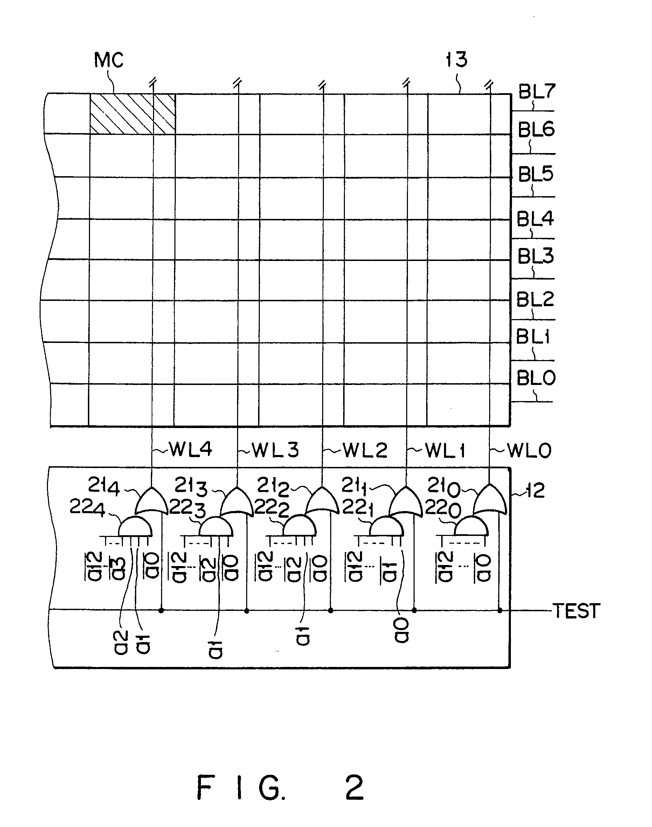

Fig. 2 shows a concrete structure of a section of each of the decoder 12 and memory cell array 13 in the EEPROM in Fig. 1. The shaded portion in the memory cell array 13 represents one of numerous nonvolatile memory cells MCs, which are arranged in matrix. These memory cells MCs are connected, in words, in parallel with word lines WL0, WL1, ..., WL4, ..., respectively. They also are connected, in bits, in parallel with 8 bit lines, BL0, BL1, ..., BL7, respectively. The word lines WL0, WL1, ..., WL4, ... are given continuous addresses in ascending order like 0, 1, ... 4.

Supplied to the decoder 12 are the test signal TEST and a plurality of bits of internal address $\overline{a0}$ through $\overline{a12}$, and a0 through a12 from the address buffer 11. The decoder 12 is provided with a plurality of 2-input OR gates $21_0$, $21_1$, ..., $21_4$, .... One input of each of OR gates $21_0$, $21_1$, ..., $21_4$, ... receives the test signal TEST, while the other inputs of OR gates $21_0$, $21_1$, ..., $21_4$, ... receive the outputs of AND gates $22_0$, $22_1$, ..., $22_4$, ..., respectively. Supplied to each of the AND gates $22_0$, $22_1$, ..., $22_4$, ... are 13 bit signals that are a unique combination of the internal address signals a0 through a12, and $\overline{a0}$ through $\overline{a12}$. The outputs of OR gates $21_0$, $21_1$, ..., $21_4$, ... are supplied to the word lines WL0, WL1, ..., WL4, ..., respectively.

In the endurance test in item (1), a 1 or a 0 is written into every bit. Since this test must be repeated nearly $10^2$ times in a short period of time, the decoder is designed to be able to erase data from and write data in all the memory cells simultaneously.

Specifically, in the circuit of Fig. 2, with the test signal TEST being set to the high state during test, the outputs of all OR gates $21_0$, $21_1$, ..., $21_4$, ... go high irrespective of the outputs of AND gates $22_0$, $22_1$, ..., $22_4$, ..., which causes all word lines WL0, WL1, ..., WL4, ... to be selected at the same time. At this time, an 8-bit write data of all 1s or 0s is supplied to the memory cell array 13.

In the retention tests, however, it is necessary to write into each word a checker pattern of an alternate logic-level 0 and 1 string. It is impossible to perform the writing/reading of such a checker pattern in the same manner as the aforementioned simultaneous erasing or writing technique. Thus, in the retention tests, data must be written in words in the same way as normal write/read operations.

As described above, EEPROMs take as long as several milliseconds to rewrite (erase/write) data. For instance, if the erase time and the write time each are 5 milliseconds, the time required to rewrite 8K words of data will be calculated as follows:

$$5 \text{ ms} + 8 \times 1024 \times 5 \text{ ms} = 40.965 \text{ s}$$

In contrast to this, the time required for the endurance test capable of simultaneous erasing/writing is approximately one second obtained by similar calculations. Additionally, the time required for other tests before shipment including the operation test, the DC test, the drawn current test, and the like is nearly three seconds. Therefore, approximately 41 seconds needed for the retention tests account for more than 90% of the test time before shipment.

Accordingly, the object of the present invention is to provide a nonvolatile semiconductor memory device capable of performing tests including the retention test in a short time without a significant increase in the size of the circuit.

The present invention provides a nonvolatile semiconductor memory device comprising: a memory cell array containing a plurality of words of nonvolatile memory elements; a plurality of word lines each of which is connected to a word of nonvolatile memory elements and is given a particular address in the memory cell array; and selecting means, which divides the word lines into a plurality of groups according to the addresses given the lines, and which selects the word lines belonging to one of the groups simultaneously based on the control signal during test.

This invention can be more fully understood from the following detailed description when taken in conjunction with the accompanying drawings, in which:

Fig. 1 is a block diagram of a conventional EEPROM;

Fig. 2 is a circuit diagram illustrating a concrete structure of a section of the conventional EEPROM of Fig. 1;

Fig. 3 is a block diagram showing the entire structure of a nonvolatile semiconductor memory device according to a first embodiment of the present invention;

Fig. 4 is a circuit diagram showing a concrete structure of a section of the first embodiment;

Fig. 5 illustrates the state in which data is stored in the memory cell array of the first embodiment;

Fig. 6 is a circuit diagram showing a concrete structure of a section of a nonvolatile semiconductor memory device according to a second embodiment of the present invention;

Fig. 7 shows the state in which data is stored in the memory cell array of the second embodiment;

Fig. 8 is a circuit diagram illustrating a concrete structure of a section of a nonvolatile semiconductor memory device according to a third embodiment of the present invention;

Fig. 9 shows the state in which data is stored in the memory cell array of the third embodiment;

Fig. 10 is a block diagram showing the entire structure of a nonvolatile semiconductor memory device according to a fourth embodiment of the present invention; and

Fig. 11 is a circuit diagram showing a concrete structure of a section of the fourth embodiment.

The present invention will be explained, referring to the accompanying drawings.

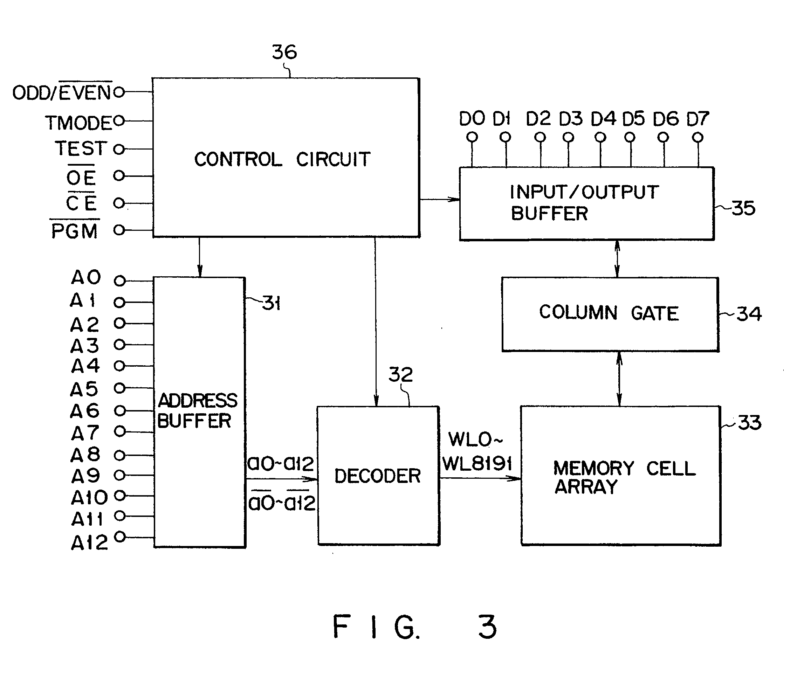

Fig. 3 is a block diagram showing the entire structure of an EEPROM according to a first embodiment of the present invention. Here, numeral 31 indicates an address buffer; 32 a decoder; 33 a memory cell array; 34 a column gate; 35 an input/output buffer; and 36 a control circuit controlling the entire memory circuit.

Thirteen bits of external address signals A0 through A12 are supplied to the address buffer 31, which in turn produces internal signals a0 through a12 and $\overline{a0}$ through $\overline{a12}$. These internal address signals a0 through a12 and $\overline{a0}$ through $\overline{a12}$ are supplied to the decoder 32, the output of which is then supplied to the memory cell array 33. The memory cell array 33 has the memory capacity to store 8192 (8K) words of data, each word being 8 bits long, or has 65536 (64K) memory cells, any of which can be selected by 8192 word lines WL0 through WL8191.

As with the conventional device, in this embodiment, it is assumed that one word of 8 memory cells in the memory cell array 33 is selected on the basis of 13 bits of external address signals and that 8 bits of data D0 through D7 is read from or written into via the column gate 34 and the input/output buffer 35.

In the memory device according to this embodiment, the control circuit 36 is supplied with: an output enable signal $\overline{OE}$, a chip enable signal $\overline{CE}$, a program signal $\overline{PGM}$, and a test signal TEST which are all used to control normal data read/write operation; a test mode signal TMODE which is set to the low state for the retention tests and to the high state for the endurance test; and an odd/even signal ODD/$\overline{EVEN}$ which is used in the retention tests to select odd-address word lines or even-address word lines.

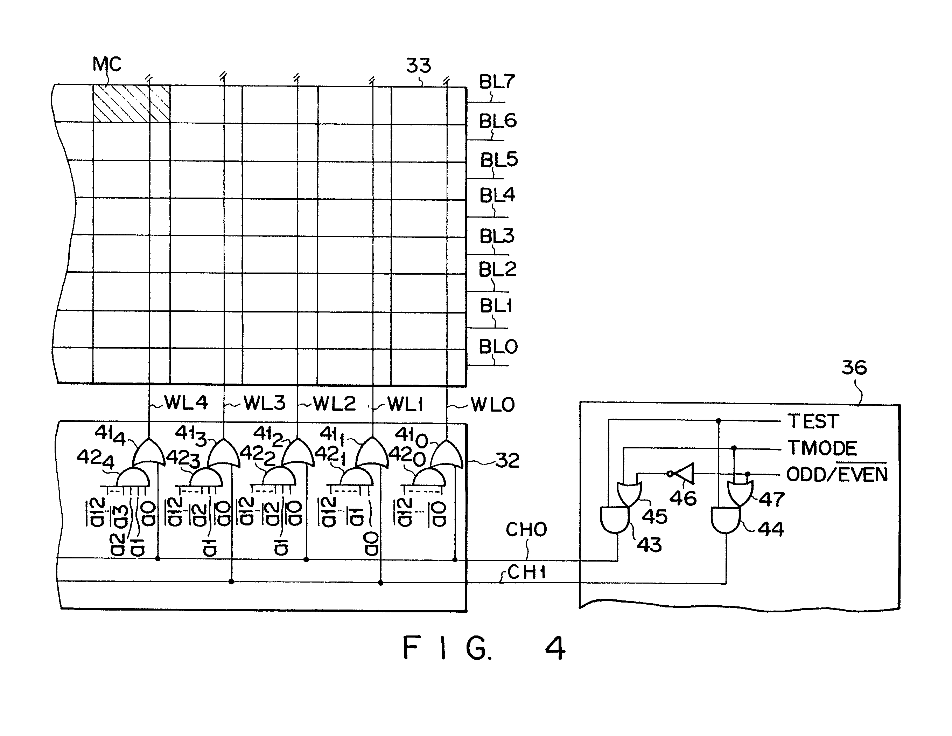

Fig. 4 illustrates a concrete structure of each of the control circuit 36, decoder 32, and memory cell array 33 in the memory device according to the embodiment.

The shaded portion in the memory cell array 33, which has numerous memory cells arranged in matrix, indicates a single nonvolatile memory cell MC. These memory cells are connected, in words, in parallel with word lines WL0, WL1, ..., WL4, ..., respectively. They also are connected, in bits, in parallel with a plurality of bit lines, BL0, BL1, ..., BL7, respectively. The word lines WL0, WL1, ..., WL4, ... are given continuous addresses in ascending order like 0, 1, ..., 4 ....

Supplied to the decoder 32 are the multiple bits of internal address a0 through a12 and $\overline{a0}$ through $\overline{a12}$ from the address buffer 31 and the two select signals CH0 and CH1. The decoder 32 contains a plurality of 2-input OR gates $41_0$, $41_1$, ..., $41_4$, ..., One input of each of OR gates $41_0$, $41_1$, ..., $41_4$, ... receives the two select signals CH0 and CH1 alternately, while the other inputs of OR gates $41_0$, $41_1$, ..., $41_4$, ... receive the outputs of AND gates $42_0$, $42_1$, ..., $42_4$, ..., respectively. Supplied to each of the AND gates $42_0$, $42_1$, ..., $42_4$, ... are 13 bit signals that are a unique combination of the internal address signals a0 through a12, and $\overline{a0}$ through $\overline{a12}$. For instance, a combination signal consisting of the internal address signals $\overline{a0}$ through $\overline{a12}$ is supplied to the AND gate $42_0$ corresponding to the word line of address 0, whereas a combination signal consisting of the internal address signals a0 and $\overline{a1}$ through $\overline{a12}$ is supplied to the AND gate $42_1$ corresponding to the word line of address 1. The outputs of OR gates $41_0$, $41_1$, ..., $41_4$, ... are supplied respectively to the word lines WL0, WL1, ..., WL4, ..., each given addresses 0, 1, ..., 4, ... in this order.

The control circuit 36 is provided with two 2-input AND gates 43 and 44, one input of each gate receiving the test signal TEST. The other input of the AND gate 43 receives the output of the 2-input OR gate 45, one input of which receives the test mode signal TMODE and the other input of which receives the odd/even signal ODD/$\overline{EVEN}$ via an inverter 46. The other input of the AND gate 44 receives the output of a 2-input OR gate 47. One input of the OR gate 47 receives the test mode signal TMODE, whereas the other input of it receives the odd/even signal ODD/$\overline{EVEN}$.

The outputs of the AND gates 43 and 44 in the control circuit 36 each are supplied as the select signals CH0 and CH1 to the decoder 32.

The operation of a memory device with the above-described structure will be explained below.

For the endurance test or the retention tests, the test signal TEST is first set to the high state. In this state, if the test mode signal TMODE is high, the endurance test mode will be selected, while if it is low, the retention test mode will be selected.

If the endurance test mode is selected when the test signal TEST is high, the select signals CH0 and CH1, which are the outputs of the 2-input AND gates 43 and 44 in the control circuit 36, both go high. This makes the outputs of all OR gates $41_0$, $41_1$, ..., $41_4$, ... of the decoder 32 high, irrespective of the outputs of the AND gates $42_0$, $42_1$, ..., $42_4$, ..., which causes all the word lines WL0, WL1, ..., WL4, ... to be selected simultaneously. At this time, 0s are written into all memory cells in the memory cell array 33, according to the write data $D_0$ through $D_7$ supplied to the input/output buffer 35.

On the other hand, if the odd/even signal

ODD/$\overline{\text{EVEN}}$ is low when the retention test mode is selected with the test mode signal TMODE low, the output of the OR gate 45 goes high and the output of the OR gate 47 goes low in the control circuit 36, which causes the output of the AND gate 43 or the select signal CH0 to go high and the output of the AND gate 44 or the select signal CH1 to go low. This makes only the outputs of the OR gates $41_0$, $41_2$, ... corresponding to the even-address word lines in the decoder 32 go high, allowing simultaneous selection of all the even-address word lines WL0, WL2, .... In contrast to this, with the odd/even signal ODD/$\overline{\text{EVEN}}$ high, the output of the OR gate 45 goes low and the output of the OR gate 47 goes high, making the output of the AND gate 43 or the select signal CH0 low and the output of the AND gate 44 or the select signal CH1 high. This makes only the outputs of the OR gates $41_1$, $41_3$, ... corresponding to the odd-address word lines in the decoder 32 go high, allowing simultaneous selection of all the odd-address word lines WL1, WL3, ....

Therefore, a checker pattern can be written into the memory cell array 33 by only two data write operations as follows: by using 8 bits of write data D0 through D7, an alternating logic-level pattern of, for example, 0, 1, 0, 1, ... is written into each of the even-address words when the odd/even signal ODD/$\overline{\text{EVEN}}$ is low, whereas the opposite pattern of 1, 0, 1, 0, ... is written into each of the odd-address words when the odd/even signal ODD/$\overline{\text{EVEN}}$ is high. Fig. 5 shows a checker pattern written into the memory cell array in the retention test.

If both of the data erasure time and the write time are 5 milliseconds as with the conventional device, the time required to write the checker pattern into the memory device according to this embodiment will be calculated: 5 ms + 2 × 5 ms = 15 ms. This figure is approximately as short as 1/2700 of nearly 40 seconds with the conventional equivalent.

Furthermore, the control circuit 36 of this embodiment requires addition of only several (five) gate circuits, making it possible to perform the retention tests in a short time without increasing the circuit size significantly.

With the test signal TEST low for normal data write/read operations, both the outputs of the AND gates 43 and 44 in the control circuit 36 or the select signals CH0 and CH1 are low. In this state, any of the address word lines is selected by the decoder 32, depending on the internal addresses a0 through a12 and $\overline{a0}$ through $\overline{a12}$, which permits normal data read/write operations.

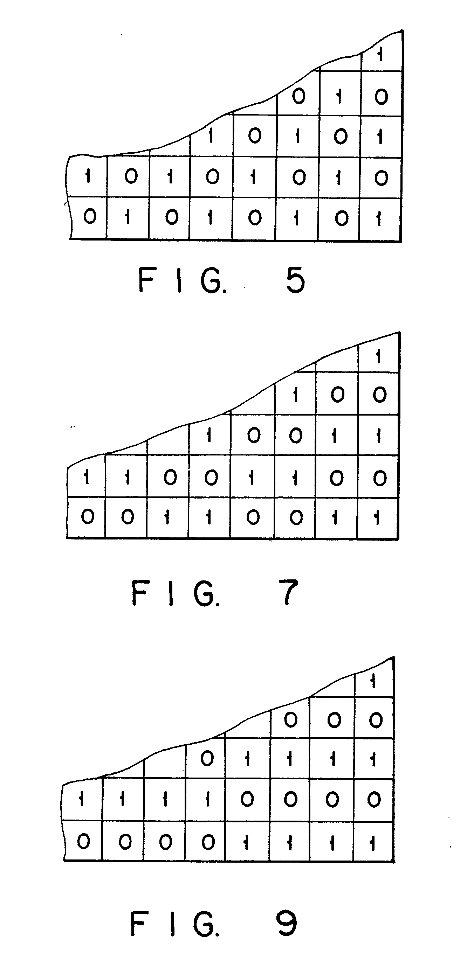

Fig. 6 illustrates a concrete structure of a section of each of the control circuit 36, decoder 32, and memory cell array 33 in a memory device according to a second embodiment of the present invention.

As with the first embodiment, in this embodiment, the decoder 32 is provided with a plurality of OR gates $41_0$, $41_1$, ..., $41_4$, ... and a plurality of AND gates $42_0$, $42_1$, ..., $42_4$, .... The decoder 32 receives a plurality of bits of internal address a0 through a12 and $\overline{a0}$ through $\overline{a12}$, and two select signals CH0 and CH1.

The control circuit 36 is provided with two AND gates 43 and 44, two OR gates 45 and 47, and an inverter circuit 46, which are arranged in the same manner as the first embodiment.

This embodiment differs from the first embodiment in the following points: in the decoder 32 of the first embodiment, the select signal CH0 is supplied to the OR gates $41_0$, $41_2$, ... connected to the even-address word lines WL0, WL2, ..., and the select signal CH1 is supplied to the OR gates $41_1$, $41_3$, ... connected to the odd-address word lines WL1, WL3, ..., while in the encoder 32 of this embodiment, the two types of the select signals CH0 and CH1 are alternately supplied to every two adjoining OR gates. For in stance, the select signal CH0 is supplied to the OR gates $41_0$ and $41_1$, whereas the select signal CH1 is supplied to the OR gates $41_2$ and $41_3$.

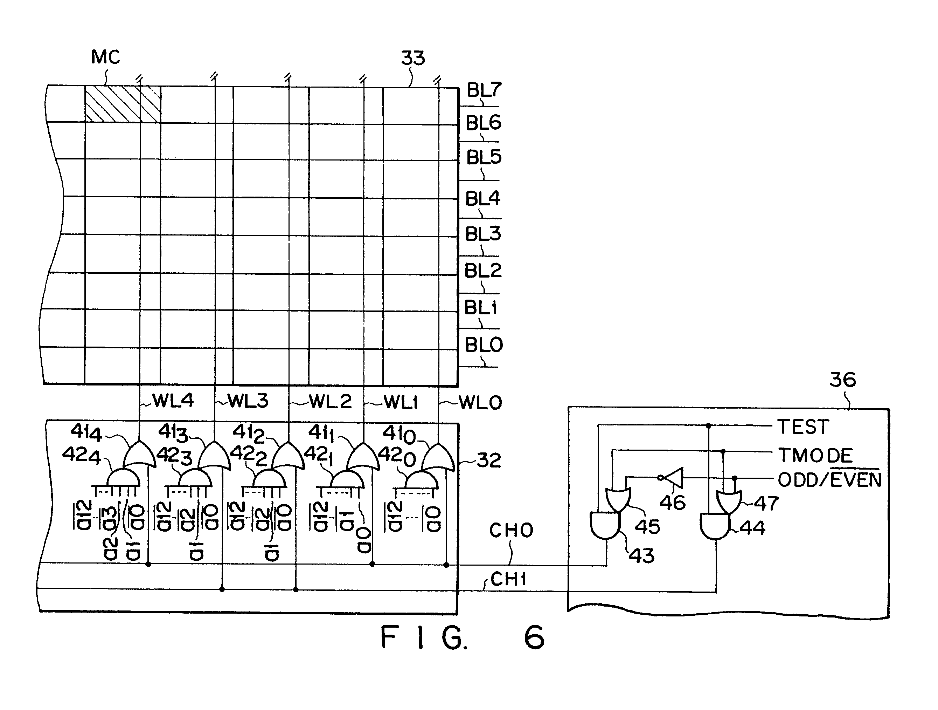

In the first embodiment, during the retention tests, a checker pattern in which data changes in bits alternately is written as shown in Fig. 5. Such a checker pattern is best suitable for evaluation of the reliability with time of the memory cells because they create a maximum electrical stress between adjacent memory cells in the memory cell array. When the retention tests are allowed under less electrical stress, the decoder 32 with the arrangement of the second embodiment may be used which permits a data pattern of inverting every two bits to be written as shown in Fig. 7.

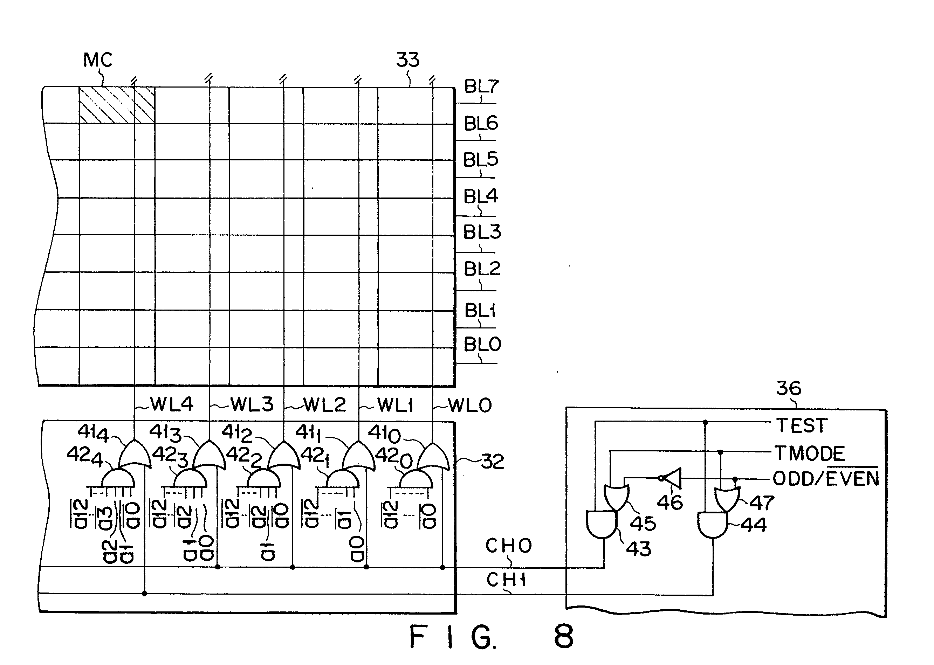

Fig. 8 shows a concrete structure of a section of each of the control circuit 36, decoder 32, and memory cell array 33 in a memory device according to a third embodiment of the present invention. In the decoder 32 of this embodiment, the two types of select signals CH0 and CH1 are supplied alternately to groups of four adjoining OR gates. For instance, the select signal CH0 is supplied to the OR gates $41_0$, $41_1$, $41_2$, $41_3$, while the select signal CH1 is supplied to the OR gate $41_4$ and the subsequent three adjoining OR gates.

Arranging the decoder 32 as described in the third embodiment allows the writing of a data pattern of alternately inverting groups of 4 bits into the memory cell array 33 as shown in Fig. 9.

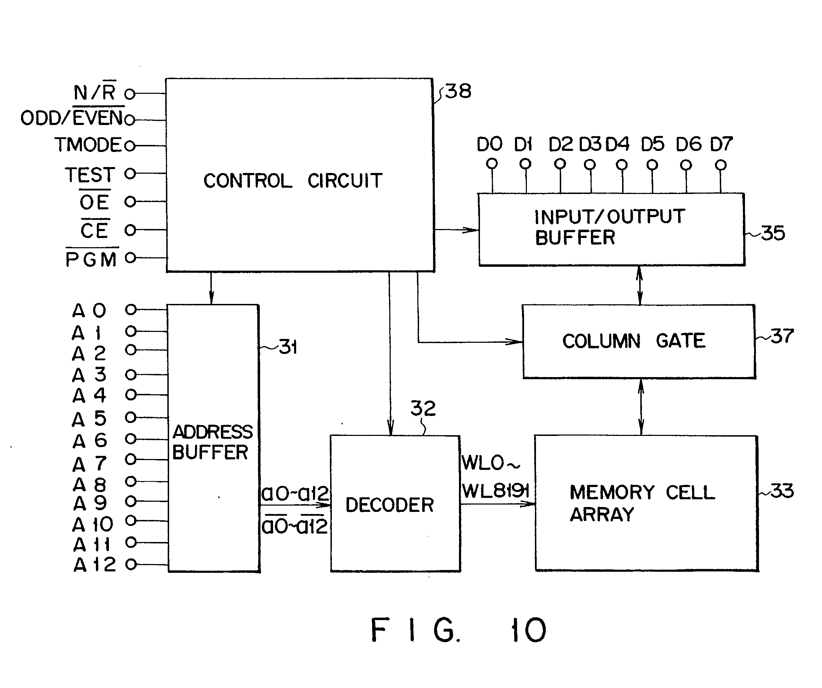

Fig. 10 is a block diagram illustrating the entire structure of a fourth embodiment of the present invention. Here, numeral 31 indicates an address buffer; 32 an decoder; 33 a memory cell array; 37 a column gate; 35 an input/output buffer; and 38 a control circuit.

In the memory device according to this embodiment, the control circuit 38 is supplied with: an output enable signal $\overline{OE}$, a chip enable signal $\overline{CE}$, a program signal $\overline{PGM}$, a test signal TEST, a test mode signal TMODE, and an odd/even number signal ODD/$\overline{EVEN}$ which are all used to control normal data read/write operations; and a normal/reverse signal N/$\overline{R}$ whose logic level is set depending on the data arrangement in the checker pattern to be written during the retention tests.

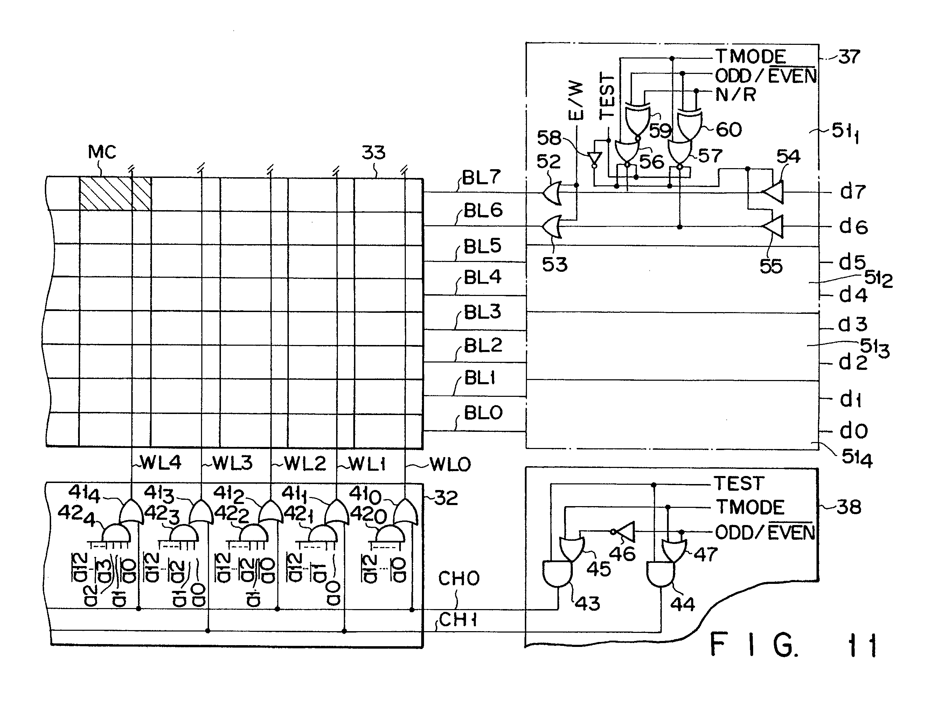

Fig. 11 is a circuit diagram illustrating a concrete structure of a section of each of the control circuit 38, decoder 32, memory cell array 33, and column gate 37 in the memory device of this embodiment.

In this embodiment, the column gate 37 contains four data generating circuits $51_1$, $51_2$, $51_3$, $51_4$ that generate data to be written into the memory cell array 33.

The data generating circuit $51_1$ is composed of two OR gates 52 and 53, two 3-state output buffers 54 and 55, two clocked NOR gates 56 and 57, an inverter 58, a CMOS exclusive NOR gate 59, and a CMOS exclusive OR gate 60. The other three data generating circuits $51_2$, $51_3$, $51_4$ also have the same configuration as the circuit $51_1$.

The odd/even signal ODD/$\overline{EVEN}$ and the normal/reverse signal N/$\overline{R}$ are supplied to the exclusive NOR gate 59, the output of which is supplied together with the test mode signal TMODE to the clocked NOR gate 56. The odd/even signal ODD/$\overline{EVEN}$ and the normal/reverse signal N/$\overline{R}$ are supplied to the exclusive OR gate 60, the output of which is supplied together with the test mode signal TMODE to the clocked NOR gate 57. Both clocked NOR gates 56 and 57 are controlled on the basis of the test signal TEST and the output of the inverter 58 that inverts the test signal: that is, they operate when the test signal TEST is high and the output of the inverter 58 is low, while they both offer high impedance when the test signal TEST is low and the output of the inverter 58 is high. The output of each of the NOR gates 56 and 57 is supplied to one of the two inputs of each of OR gates 52 and 53, respectively.

The 3-state output buffers 54 and 55 are each controlled on the basis of the output of the inverter 58: that is, they supply 2 bits of input data d7 and d6, without any change in their level, to one of the two inputs of each of the OR gates 52 and 53 when the output of the inverter 58 is high, while they both present high impedance when the output of the inverter 58 is low.

The other input of each of the OR gates 52 and 53 receives the erase/write control signal E/$\overline{W}$ from the control circuit 38. Then, the outputs of both OR gates 52 and 53 are supplied as write data to the bit lines BL7 and BL6, respectively. The other data generating circuits $51_2$, $51_3$, $51_4$ are all arranged in the same manner as the data generating circuit $51_1$ except for the following point only: they vary from each other in the 2-bit input data supplied to the 3-state output buffers 54 and 55. Specifically, the 2-bit input data of d5 and d4 are supplied to the two 3-state output buffers 54 and 55 respectively in the data generating circuit $51_2$; the 2-bit input data of d3 and d2 are supplied to the two 3-state output buffers 54 and 55 respectively in the data generating circuit $51_3$; and the 2-bit input data of d1 and d0 are supplied to the two 3-state output buffers 54 and 55 respectively in the data generating circuit $51_4$. The 8-bit input data of d7 through d0 has data level corresponding to the write data of D7 through D0 supplied to the input/output buffer 35.

With this arrangement, when the endurance test mode is selected, all the word lines WL0, WL1, WL4, ... are selected simultaneously by the decoder 32 as described before. In this state, the test signal TEST is high, which makes the output of the inverter 58 in each of the four data generating circuit low, causing the outputs of all pairs of the 3-state output buffers 54 and 55 to be of high impedance. The high test signal TEST permits the clocked NOR gates 56 and 57 to operate, whereas the high test mode signal TMODE makes all the outputs low. In this state, the erase/write control signal E/$\overline{W}$ is set high for erasure, which makes both outputs of the two OR gates 52 and 53 in each of the data generating circuits high, causing 1 to written into all the memory cells MCs in the memory cell array 33 via the bit lines BL0 through BL7, with the result that all bits are erased.

In the state where the endurance test mode is selected, the erase/write control signal E/$\overline{W}$ is low during write operation, both OR gates 52 and 53 in each data generating circuit are low, which causes 0s to be simultaneously written into all memory cells MCs in the memory cell array 33.

The operation when the retention mode is selected will be explained. In this mode, when both the normal/reverse signal N/$\overline{R}$ and the odd/even signal ODD/$\overline{EVEN}$ are high, the data generating circuit $51_1$ supplies data of alternate high and low levels to the bit lines BL7 and BL6. Namely, with ODD/$\overline{EVEN}$ = high and N/$\overline{R}$ = high, the output of the exclusive NOR gate 59 is high and the output of the exclusive OR gate 60 is low, which makes the output of the clocked NOR gate 56 low and the output of the clocked NOR gate 57 high. Since the other data generating circuits $51_2$, $51_3$, and $51_4$ operate in the same way, the bit lines BL7 through BL0 receives data whose logic level changes alternately like H (high), L (low), H, L, H, L, H. L." When the odd/even signal ODD/$\overline{EVEN}$ is high, one control signal CH1 is set to high by the control circuit 38 as described above, which allows the decoder 32 to simultaneously select the odd-address word lines WL1, WL3, .... As a result, data with a pattern of 1, 0, 1, 0, 1, 0, 1, 0 are written, via the bit lines BL7 through BL0 in that order, into the 8 memory cells connected to the odd-address word lines.

On the other hand, when the odd/even signal ODD/$\overline{\text{EVEN}}$ is low, or when the decoder 32 selects the even-address word lines WL0, WL2, ... simultaneously, the bit lines BL7 through BL0 receives data whose logic level changes alternately like L (low), H (high), L, H, L, H, L, H." As a result of this, data with a pattern of 0, 1, 0, 1, 0, 1, 0, 1 are written, via the bit lines BL7 through BL0 in that order, into the 8 memory cells connected to the even-address word lines.

In the above embodiment, if the normal/reverse signal N/$\overline{\text{R}}$ is set to low, the checker pattern will be written with the 1 and 0 positions reversed.

As described above, this embodiment is also able to write a checker pattern into the memory cell array 33 through just two write operations. Moreover, since this embodiment contains the data generating circuitry in the column gate 37, it is not necessary to externally supply write data even when the retention and endurance tests are performed.

While in the embodiments described above, the present invention is applied to EEPROMs, it may be applicable to EPROMs having ultraviolet-ray erasable memory cells, offering similar results.

Accordingly, this invention provides a nonvolatile semiconductor memory that can perform tests including the retention tests in a short period of time without increasing the circuit size significantly.

Reference signs in the claims are intended for better understanding and shall not limit the scope.

## Claims

1. A nonvolatile semiconductor memory device, comprising:

   a memory cell array (33) containing a plurality of words of nonvolatile memory elements;

   a plurality of word lines (WL0 through WL8191) each of which is connected to one word of nonvolatile memory elements in said memory cell array and is given a particular address in said memory cell array; and

   selecting means (31, 32, 36; 31, 32, 38) which divides the word lines into a plurality of groups depending on the addresses each given to the word lines and which simultaneously selects the word lines belonging to one of the groups according to the control signal during test.

2. A nonvolatile semiconductor memory device according to claim 1, characterized in that said selecting means selects either the even-address group of word lines or the odd-address group of word lines simultaneously, depending on said control signal.

3. A nonvolatile semiconductor memory device according to claim 2, characterized in that said selecting means includes:

   an address buffer (31) which receives an external address signal consisting of a plurality of bits to select said word lines and produces an internal address signal based on the external address signal;

   a control circuit (36, 38) which receives a first control signal (ODD/$\overline{\text{EVEN}}$) to distinguish between the even-address group of word lines and the odd-address group of word lines and which produces a second and third control signals (CH0, CH1) based on the logic level of the first control signal; and

   a decoder (32) which receives said internal address signal of a plurality of bits and said second and third internal control signals, and which selects the word lines based on those internal address signal and second and third control signals.

4. A nonvolatile semiconductor memory device according to claim 3, characterized in that said control circuit further receives a fourth control signal (TEST) to select either the normal data read/write operation or the test operation for said memory cell array and includes:

   an inverter circuit (46) which inverts the logic level of said first control signal;

   a first AND gate circuit (43) which receives said fourth control signal and the output of said inverter circuit and produces said second control signal; and

   a second AND gate circuit (44) which receives said fourth control signal and said first control signal and produces said third control signal.

5. A nonvolatile semiconductor memory device according to claim 4, characterized in that said decoder includes:

   . a plurality of third AND gate circuits (42) which each provide for said corresponding word lines and each receive said internal address signal con sisting of a plurality of bits (a0 through a12, $\overline{\text{a0}}$ through $\overline{\text{a12}}$); and

   a plurality of first OR gate circuits (41) which each provide for said corresponding word lines and each receive the output of said corresponding third AND gate circuits and one of said second and third control signals.

6. A nonvolatile semiconductor memory device according to claim 3, characterized in that said control circuit further receives a fourth control signal (TEST) to select either the normal data read/write operation or said memory-cell array test operation and a fifth control signal (TMODE) to select either said endurance test or said retention test of said memory cell array, and includes:

an inverter circuit (46) which inverts the logic level of said first control circuit;

a second OR gate (45) which receives said fifth control signal and the output of said inverter circuit;

a third OR gate circuit (47) which receives said fifth control signal and said first control signal;

a fourth AND gate circuit (43) which receives said fourth control signal and the output of said second logical-sum gate circuit and produces said second control circuit; and

a second OR gate circuit (44) which receives said fourth control signal and the output of said second logical-sum gate circuit and produces said third control signal.

7. A nonvolatile semiconductor memory device according to claim 1, characterized by further comprising data generating means ($51_1$ through $51_4$) for generating data consisting of a plurality of bits to be written into said memory cell array during test.

8. A nonvolatile semiconductor memory device according to claim 2, characterized by further comprising data generating means ($51_1$ through $51_4$) for generating data consisting of a plurality of bits to be written into said memory cell array during test, wherein said data generating means generates data of an alternate logical 1 and 0 string when one of the even-address group and the odd-address group of the word lines is selected by said selecting means, while it generates data of an alternate logical 0 and 1 string when the other of the even-address group and the odd-address group of the word lines is selected.

F I G. 1

EP 0 450 632 A2

FIG. 2

F I G. 3

EP 0 450 632 A2

F I G. 4

F I G. 5

F I G. 7

F I G. 9

F I G. 6

F I G. 8

EP 0 450 632 A2

EP 0 450 632 A2

F I G. 10

F I G. 11